**Europäisches Patentamt**

**European Patent Office**

**Office européen des brevets**

(19)

(11) Numéro de publication: **0 139 334**
**B1**

# (12) FASCICULE DE BREVET EUROPEEN

(45) Date de publication du fascicule du brevet:
**28.12.88**

(51) Int. Cl.⁴: **H 01 L 23/14, H 01 J 1/34**

(21) Numéro de dépôt: **84201490.4**

(22) Date de dépôt: **16.10.84**

(54) **Structure semiconducteur-support vitreux et dispositifs réalisés avec une telle structure.**

(30) Priorité: **19.10.83 FR 8316636**

(43) Date de publication de la demande:
**02.05.85 Bulletin 85/18**

(45) Mention de la délivrance du brevet:
**28.12.88 Bulletin 88/52**

(84) Etats contractants désignés:
**DE FR GB**

(56) Documents cités:
**EP-A- 0 078 583**
**FR-A- 2 325 175**
**GB-A- 1 476 471**
**GB-A- 1 535 061**

(73) Titulaire: **Laboratoires d'Electronique et de Physique Appliquée L.E.P., 3, Avenue Descartes, F-94450 Limeil-Brévannes (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB**

(72) Inventeur: **Jarry, Philippe Société Civile S.P.I.D., 209, rue de l'Université, F-75007 Paris (FR)**
Inventeur: **Haji, Mohamed Lazhar Société Civile S.P.I.D., 209, rue de l'Université, F-75007 Paris (FR)**
Inventeur: **Guittard, Pierre Société Civile S.P.I.D., 209, rue de l'Université, F-75007 Paris (FR)**
Inventeur: **Guillemet, Bernard Société Civile S.P.I.D., 209, rue de l'Université, F-75007 Paris (FR)**
Inventeur: **Piaget, Claude Société Civile S.P.I.D., 209, rue de l'Université, F-75007 Paris (FR)**

(74) Mandataire: **Landousy, Christian et al, Société Civile S.P.I.D. 209, Rue de l'Université, F-75007 Paris (FR)**

**Description**

L'invention concerne une structure semiconducteur-support vitreux formée:
– de couches semiconductrices constituées au moins d'une couche d'un composé n-aire III–V, active électriquement et/ou optiquement et au moins d'une couche complémentaire,
– et d'un support vitreux pour recevoir les couches semiconductrices. Une telle structure est connue de EP-A-0 078 583.

L'invention concerne notamment les dispositifs optoélectroniques à semiconducteurs, c'est-à-dire les dispositifs permettant la manipulation (transmission, traitement et stockage) d'informations d'origine optique, au moyen d'un ensemble électronique, dans lesquels les semiconducteurs interviennent d'abord en tant que convertisseurs entre les photons et les électrons. L'invention concerne plus particulièrement les photocathodes de type III–V, ainsi que les dispositifs à transfert de charges (CCD pour «charge coupled device»).

Dans ces dispositifs optoélectroniques particuliers, les semiconducteurs sont utilisés sous forme d'un empilement de couches semiconductrices, et du fait du scellement entre ces couches semiconductrices et un support vitreux à des températures relativement élevées, il apparaît des contraintes d'origine thermique qui se traduisent généralement par une courbure de ces couches semiconductrices, contraintes qui peuvent également conduire à la dégradation des qualités électriques du semiconducteur et, à l'extrême, à des fractures du matériau actif préjudiciables au bon fonctionnement desdits dispositifs.

L'invention vise à pallier les susdits inconvénients par une meilleure adaptation entre les couches semiconductrices et le support vitreux.

Une telle structure semiconducteur-support vitreux est décrite dans le document FR-A-2 538 620, publié le 29 juin 1984. Il y est proposé de contrôler l'évolution des contraintes dans la couche active en introduisant dans certaines des couches complémentaires, initialement formées de (Ga, Al) As, une certaine quantité de phosphore afin de former le composé quaternaire (Ga, Al) (As, P), (que le métallurgiste considère comme un composé pseudo-binaire III–V), le but étant de faire passer la couche active d'un état d'extension à un état de compression. Mais la maîtrise des différents paramètres de croissance peut s'avérer difficile dans certains cas. Aussi la présente invention propose de conserver la structure habituelle des couches semiconductrices et de contrôler leur état de compression-extension en intervenant au niveau du support vitreux.

Conformément à la présente invention, cette structure semiconducteur-support vitreux est remarquable en ce que le coefficient de dilatation de la couche de composé n-aire III–V est supérieur au coefficient (apparent) de dilatation de la (des) couche(s) complémentaire(s), et en ce que le support vitreux, qui permet de contrôler l'état de compression-extension desdites couches semiconductrices sur une large gamme de température, est formé de deux verres différents soudés entre eux à savoir:
  a) un verre de soutien ayant un coefficient de dilatation et une température de ramollissement supérieurs respectivement au coefficient (apparent) de dilatation de la (des) couche(s) complémentaire(s) et aux températures de traitement de ladite structure après qu'elle ait été réalisée,
  b) un verre tampon, placé entre le verre de soutien et la (les) couche(s) complémentaire(s), ayant une température de ramollissement plus faible que celle du verre de soutien.

De cette manière, on obtient une structure semiconducteur-support vitreux, pour laquelle les contraintes d'extension de la couche active se trouvent ramenées dans un état de compression par l'action du support vitreux, sans action de couches semiconductrices nouvelles, lesdites contraintes ayant des valeurs telles que les déformations sont de type élastique pour des conditions voisines de celles de la température ambiante.

La description qui va suivre, en regard des dessins annexés, donnés à titre non limitatif, permettra de mieux comprendre comment l'invention s'exécute et se poursuit.

La figure 1 représente les différentes étapes de réalisation, de scellement et de recuit d'une structure semiconducteur-support vitreux, selon l'art antérieur.

La figure 2 représente ces mêmes étapes selon la présente invention, le support vitreux étant constitué de deux verres soudés entre eux.

La figure 3 représente l'évolution du coefficient de dilatation thermique avec la température pour un verre recuit donnée à titre de référence.

Un exemple typique de structure semiconducteur-support vitreux est constitué par la photocathode III–V, telle que décrite dans le document FR-A-2 538 620 publié le 29 juin 1984.

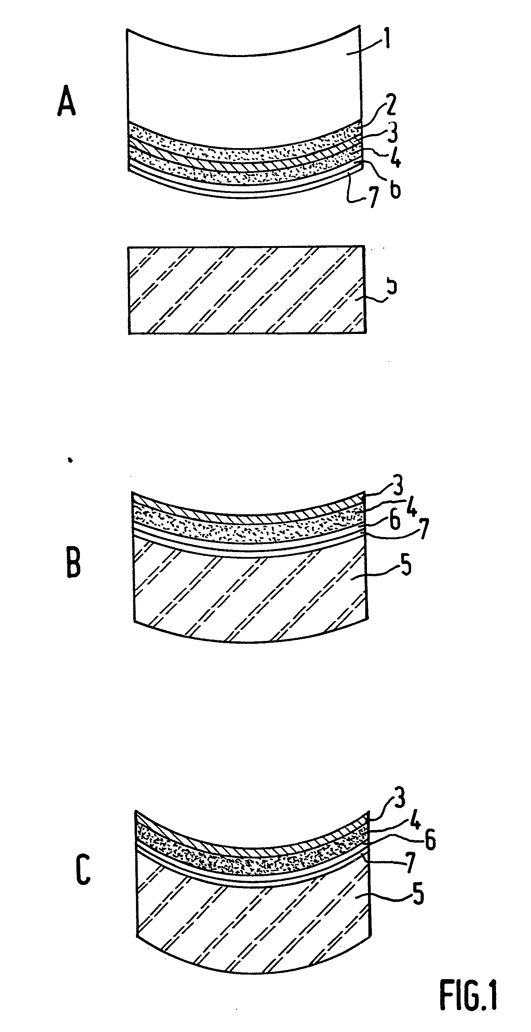

La fabrication d'une telle structure comprend des étapes de réalisation d'une hétérostructure semiconductrice, de scellement sur un support vitreux et enfin de traitement thermique sous vide, ces étapes étant décrites en référence à la figure 1, dessins A, B, C.

La réalisation d'une hétérostructure semiconductrice (figure 1, dessin A) consiste à faire croître, typiquement par épitaxie en phase liquide, sur un substrat provisoire 1 d'un composé III–V, tel que l'arséniure de gallium GaAs, une couche 2 dite d'arrêt chimique $Ga_{1-x} Al_x$ As, qui agit comme une couche d'arrêt vis-à-vis de l'action de la solution de décapage utilisée pour enlever le substrat provisoire 1. Une épaisseur de couche d'arrêt 2 de l'ordre de 0,5 à 5 μm a conduit à des résultats satisfaisants. On fait croître ensuite une couche 3 dite active, généralement d'arséniure de gallium très fortement dopé jusqu'à $10^{19}$ atomes/cm³, par exemple au moyen des espèces dopantes germanium (Ge) ou zinc (Zn) ou encore d'une combinaison d'espèces dopantes, ce qui permet d'accroître le dopage sans nuire à la qualité cristalline de la couche, ainsi que décrit dans le document FR-A-2 535 359 publié le 4 mai 1984. Une épaisseur de couche active 3 de l'ordre de 2 à 5 μm semble

convenir pour une application en tant que photocathode. On forme enfin une couche 4 dite passivante pour empêcher la diffusion de substances indésirables dans la couche active 3 lors des étapes ultérieures de scellement, et pour diminuer la recombinaison des porteurs de charge à l'interface. Une couche passivante 4 de $Ga_{1-y} Al_y As$ d'une épaisseur de l'ordre de 5 μm satisfait à cet usage.

La répartition et l'évolution des contraintes, dans une telle hétérostructure, est relativement complexe. Les paramètres des mailles cristallines de l'arséniure de gallium (GaAs) et de l'arséniure de gallium et d'aluminium ($Ga_{1-x} Al_x As$) étant quasiment égaux à la température de croissance, l'hétérostructure est à cette température (800 °C) sans contrainte. Par contre, à la température ambiante, le paramètre de maille du GaAs étant inférieur à celui de $Ga_{1-x} Al_x As$ et l'épaisseur du substrat provisoire 1 étant largement supérieure à celles des couches épitaxiales 2, 3 et 4, la couche active 3 est mise en extension la courbure de l'ensemble étant telle que, vu depuis la surface libre de la dernière couche déposée 4, l'ensemble de la structure est convexe.

Cette hétérostructure semiconductrice, munie de couches de protection et d'adaptation d'indice, est alors liée à un support vitreux, transparent aux photons, en vue d'obtenir une photocathode fonctionnant en transmission (figure 1, dessin B). Ce support vitreux est généralement un verre borosilicate 5, et typiquement le verre produit par la firme CORNING, sous la référence 7056. La liaison est obtenue par thermocompression en élevant la température juste au-dessus de sa température de ramollissement (vers 700 °C pour le verre 7056), et en maintenant l'ensemble sous une pression de l'ordre de 10 kg/cm², le temps nécessaire pour que la liaison s'effectue. L'épaisseur du support vitreux n'est pas très critique et peut être de l'ordre de 1 à 10 mm. Une fois la liaison effectuée, le substrat provisoire 1 et la couche d'arrêt 2 sont décapés au moyen de deux solutions d'attaque différentes; dans l'exemple décrit, le substrat provisoire 1 de GaAs est attaqué au moyen d'un mélange ammoniaque et eau oxygénée, alors que la couche d'arrêt 2, insensible à cette première solution d'attaque, est retirée au moyen d'acide fluorhydrique après protection du support vitreux. Le produit obtenu comprend alors, un support vitreux 5 faisant office de fenêtre d'entrée, une couche d'adaptation d'indice 6 de $Si_3N_4$, une couche de protection 7 de $SiO_2$, une couche passivante 4 et une couche active 3 de très bonne qualité. Les couches d'adaptation d'indice 6 de $Si_3N_4$, de protection 7 de $SiO_2$ et la couche passivante 4 constituent, dans le cas présent, les couches complémentaires dont le nombre et la nature peuvent éventuellement être modifiés en fonction de l'application.

Lors du scellement, à la température de ramollissement du verre, ladite structure est pratiquement sans contrainte. Au cours du refroidissement, l'hétérostructure semiconductrice est liée au verre dont le coefficient de dilatation est inférieur à ceux des diverses couches semiconductrices, de sorte que les couches semiconductrices sont mises en extension. L'élimination du substrat provisoire 1 et de la couche d'arrêt 2 peut même modifier ces contraintes.

Enfin, avant utilisation de cette structure semiconducteur-support vitreux comme photocathode, on procède à une désorption sous vide de la surface de la couche active de GaAs, par chauffage jusqu'à une température proche du point d'évaporation congruente du composé, qui, pour le GaAs, est voisin de 630 °C.

A cette température de désorption, la couche active semiconductrice 3 de GaAs voit l'effet des contraintes diminué du fait des déformations élastiques respectives de GaAs et de (Ga, Al) As. A la température de transformation de phase du verre, l'hétérostructure semiconductrice est à nouveau liée rigidement au verre, et la couche active est à nouveau remise en extension.

Du point de vue purement mécanique, il est bien connu que les matériaux résistent mieux à des contraintes de compression qu'à des contraintes d'extension. Ces dernières provoquent notamment des glissements de dislocations, des micro-fractures, etc. ..., alors que les premières apparaissent moins génératrices de défauts.

Du point de vue électronique, les défauts cristallins sont autant de pièges pour les porteurs de charge et autant de centres de recombinaison, de sorte que la longueur effective de diffusion des porteurs de charge chute de façon sensible lorsque la densité de pièges s'accroît.

L'invention vise à réduire l'apparition des défauts cristallins dus aux contraintes mécaniques et à améliorer ainsi les performances des dispositifs semiconducteurs élaborés à partir de ces couches semiconductrices.

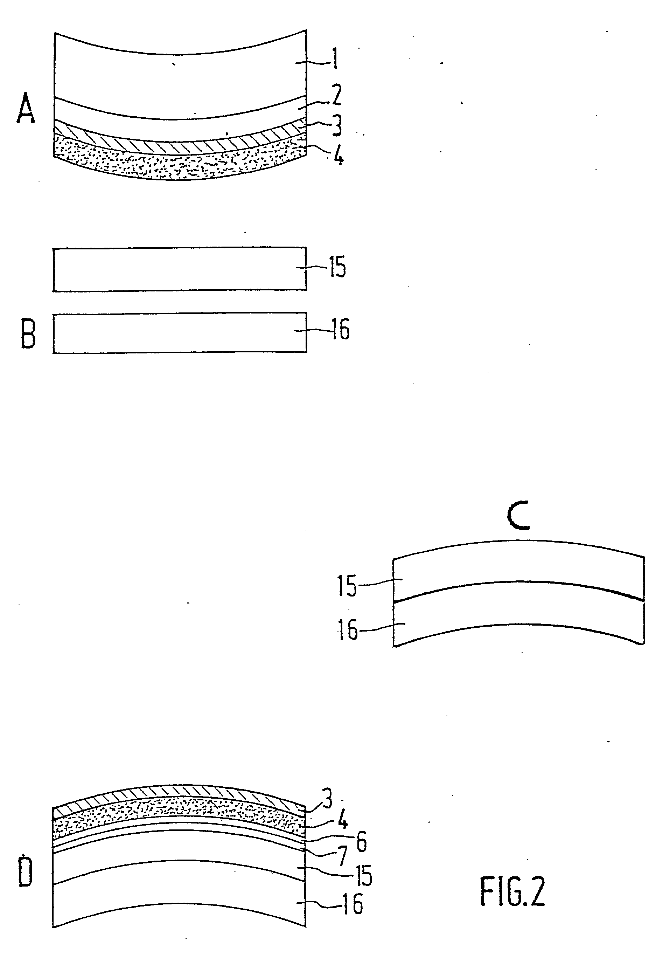

Selon la présente invention, telle que décrite en référence à la figure 2, le support vitreux est constitué de deux verres soudés entre eux, afin que la couche active 3 constituant les couches semiconductrices soit gardée dans un état de compression, afin d'éviter la dégradation de ses propriétés électriques en ce qui concerne en particulier la longueur de diffusion des porteurs de charge.

Les verres, qui sont des substances amorphes, ne possèdent pas comme les substances cristallines des propriétés qui varient brutalement avec la température en particulier un point de fusion mais au contraire des propriétés qui varient continûment avec la température. L'art ancien et complexe des verriers conduit à définir un certain nombre de repères en fonction de la température basés essentiellement sur la viscosité du verre η. L'échelle de grandeur du paramètre η définissant la viscosité étant très étendue les paramètres mesurés sont généralement exprimés en fonction du logarithme de η.

· Lorsque log η > 15    il s'agit du domaine solide

· Lorsque 8 ≤ log η ≤ 15    il s'agit du domaine de transformation

· Lorsque    log η < 8    il s'agit du domaine liquide.

Parmi les différentes températures inventoriées, celles qui concernent la présente invention sont:

– la température de contrainte pour laquelle log $\eta$ = 14,5; c'est la température à laquelle les tensions internes du verre se relâchent au bout de 4 heures.

– la température de recuit pour laquelle log $\eta$ = 13,0; c'est la température à laquelle les tensions internes du verre sont à peu près complètement relâchées au bout de 15 minutes.

– la température de ramollissement pour la- quelle log $\eta$ = 7,6; c'est la température à laquelle on peut courber le verre.

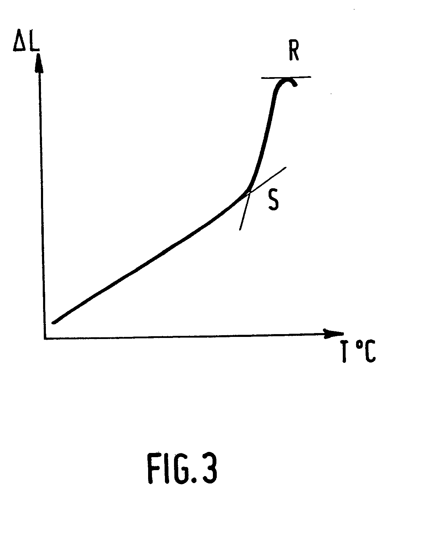

Pour caractériser les propriétés thermovis- queuses des verres on considère l'évolution du coefficient de dilatation linéaire avec la température. Ainsi que cela est indiqué sur la figure 3 donnée en référence dans le cas d'un verre recuit, on définit deux points particuliers S et R. Le point S correspond au point de croisement des tangentes aux deux points d'inflexion de la courbe représentée. On l'appelle température de transforma- tion pour laquelle log $\eta$ = 13,3. Le point R est le point de ramollissement dilatométrique qui correspond à un début d'affaiblissement du verre, pour lequel on a log $\eta$ = 15.

Dans la structure complète après épitaxie utilisée dans la cadre de l'invention, la partie de structure constituée de la couche active de GaAs 3 présente la particularité d'être mise naturellement en état d'extension, compte tenu des coefficients de dilatation linéaire respectifs:

$$\alpha (GaAs) = 74,6 . 10^{-7}\,°C^{-1}$$
$$\alpha (Ga_{0,5}\,Al_{0,5}\,As) = 63,3 . 10^{-7}\,°C^{-1}$$

et compte tenu du fait que la couche passivante présente une épaisseur plus élevée que celle de la couche active.

En ce qui concerne les coefficients de dilatation, les propriétés thermoélastiques du support vitreux sont à adapter à la couche complémentaire la plus épaisse, la couche passivante 4 dans le cas présent. Mais si des couches complémentaires intermédiaires existent, les couches d'adaptation d'indice 6 de $Si_3N_4$ et de protection 7 de $SiO_2$ dans le cas présent, il est nécessaire de considérer l'incidence qu'elles ont et d'évaluer un coefficient de dilatation apparent pour l'ensemble des couches complémentaires.

Dans la réalisation particulière considérée dans le cadre de l'invention les couches semiconductrices telles qu'elles adviennent après obtention de la structure dite «inversée» sont constituées de l'empilement des couches semiconduc- trices suivantes:

GaAs / (Ga, Al) As / $Si_3N_4$ / $SiO_2$.

Les couches de $Si_3N_4$ et $SiO_2$ d'épaisseur d'envi- ron 100 nm chacune ont respectivement un rôle de couche antireflets et de protection et ont une incidence négligeable sur la répartition des contraintes.

En fonction de la teneur en Al As le coefficient de dilatation de la couche passivante de (Ga, Al) As va pouvoir se situer entre
$\alpha$ = 74,6 . $10^{-7}$/°C pour GaAs
$\alpha$ = 52,0 . $10^{-7}$/°C pour Al As.

Il est souhaitable que le coefficient de dilatation du verre utilisé soit supérieur à celui de la couche de (Ga, Al) As pour tout le domaine de température, afin que les contraintes dans le semiconducteur soient compensées, mais également que la température de ramollissement du verre ne soit pas trop élevée sinon les contraintes engendrées après le scellement seront élevées.

Il apparaît que des exigences contradictoires sont demandées au support vitreux. Aussi l'invention propose d'utiliser deux verres différents l'un, le verre tampon 15, apportant ses propriétés thermoélastiques, l'autre, le verre de soutien 16 apportant sa température de ramollissement élevée.

Afin d'utiliser la structure semiconducteur- support vitreux selon l'invention pour constituer une photocathode, il est nécessaire de lui faire subir un traitement de surface comprenant une désorption sous vide à une température voisine de 630 °C suivie d'un traitement de couverture par du caesium-oxygène, sous vide, à température ambiante, pour abaisser le travail de sortie. Mais pour ne pas contaminer la couche semiconductrice active ainsi nettoyée, il est nécessaire que ce traitement se fasse rapidement, c'est-à-dire en 30 minutes environ. Or le support vitreux nécessiterait quant à lui une procédure particulière, faite de paliers de température successifs, bien maîtrisée par les verriers, mais qui ne peut être respectée dans le cas présent. Ce non-respect des paliers de température conduit à une propagation des contraintes diverses dans les couches semiconductrices. C'est pour surmonter ces difficultés que l'invention propose d'utiliser deux verres différents.

La couche complémentaire qui, dans l'exemple donné, impose ses caractéristiques de dilatation au support vitreux est la couche de (Ga, Al) As avec une teneur en Al As voisine de 0,5 pour laquelle le coefficient de dilatation se situe aux environs de 63 · $10^{-7}$/°C. Pour garder la couche semiconductrice active 3 dans un état qui tende vers la compression il faut que le verre tampon 15 ait un coefficient de dilatation inférieur à celui de cette couche semiconductrice active 3 mais avec une température de recuit inférieure ou égale à la température de désorption sous vide de 630 °C. De même, il faut que le verre de soutien 16 ait une température de recuit voisine de la température de désorption sous vide de 630 °C. En conséquence ces différentes nécessités imposent que le support vitreux soit formé:

a) d'un verre de soutien ayant un coefficient de dilatation et une température de ramollissement supérieurs respectivement au coefficient (apparent) de dilatation de la (des) couche(s) complémentaire(s) et aux températures de traitement de ladite structure après qu'elle ait été réalisée,

b) d'un verre tampon, placé entre le verre de soutien et la (les) couche(s) complémentaire(s), ayant une température de ramollissement plus faible que celle du verre de soutien.

Le tableau I résume leurs caractéristiques.

Tableau I

|  | CORNING n° 7056 | Ca B Al Si | SCHOTT n° 8436 |
|---|---|---|---|
| Coefficient de dilatation | $51,5.10^{-7}/°C$ | $60,1.10^{-7}/°C$ | $66.10^{-7}/°C$ |
| Température de contrainte | 472 °C | 600 °C | |
| Température de recuit | 512 °C | 630 °C | 630 °C |
| Température de transformation | | | 620 °C |
| Température de ramollissement | 475 °C | 520 °C | 620 °C |

En conséquence, le verre tampon 15 pourra être le verre CORNING n° 7056 ou le verre Ca B Al Si dont la composition centésimale molaire est donnée par:

CaO 20 à 30%, $B_2O_3$ 50 à 60%, $Al_2O_3$ 5 à 10%, $SiO_2$ 10 à 15%.

Le verre de soutien 16 pourra être le verre SCHOTT n° 8436 ou le même verre Ca B Al Si. On obtient ainsi les couples verre tampon/verre de soutien formés de:

CORNING n° 7056 / SCHOTT n° 8436
Ca B Al Si / SCHOTT n° 8436.

Bien évidemment d'autres compositions de verre peuvent être utilisées dans la mesure où elles correspondent aux caractéristiques de la présente invention.

**Revendications**

1. Structure semiconducteur-support vitreux formée:

– de couches semiconductrices constituées au moins d'une couche d'un composé n-aire III–V, active électriquement et/ou optiquement et au moins d'une couche complémentaire,

– et d'un support vitreux pour recevoir les couches semiconductrices,

caractérisée en ce que le coefficient de dilatation de la couche de composé n-aire III–V est supérieur au coefficient (apparent) de dilatation de la (des) couche(s) complémentaire(s), et en ce que le support vitreux, qui permet de contrôler l'état de compression-extension desdites couches semiconductrices sur une large gamme de température, est formé de deux verres différents soudés entre eux à savoir:

a) un verre de soutien ayant un coefficient de dilatation et une température de ramollissement supérieurs respectivement au coefficient (apparent) de dilatation de la (des) couche(s) complémentaire(s) et aux températures de traitement de ladite structure après qu'elle ait été réalisée,

b) un verre tampon, placé entre le verre de soutien et la (les) couche(s) complémentaire(s), ayant une température de ramollissement plus faible que celle du verre de soutien.

2. Structure semiconducteur-support vitreux selon la revendication 1, caractérisée en ce que le support vitreux est constitué:

a) du verre tampon formé du verre tel celui disponible auprès de la Société CORNING sous la référence 7056;

b) du verre de soutien formé du verre tel celui disponible auprès de la Société SCHOTT sous la référence 8436.

3. Structure semiconducteur-support vitreux selon la revendication 1, caractérisée en ce que le support vitreux est constitué:

a) du verre tampon formé d'un verre appelé Ca B Al Si ayant la composition centésimale molaire suivante:

CaO 20 à 30%, $B_2O_3$ 50 à 60%, $Al_2O_3$ 5 à 10%, $SiO_2$ 10 à 15%;

b) du verre de soutien formé du verre tel celui disponible auprès de la Société SCHOTT sous la référence 8436.

4. Photocathode caractérisée en ce qu'elle comprend une structure semiconducteur-support vitreux selon l'une des revendications 1 à 3.

5. Dispositif à transfert de charges caractérisé en ce qu'il comprend une structure semiconducteur-support vitreux selon l'une des revendications 1 à 3.

## Claims

1. A vitreous semiconductor supporting structure formed:
- by semiconductor layers constituted at least by a layer of an n-ary III–V compound, electrically and/or optically active and at least by complementary layer,
- and by a vitreous support to receive the semiconductor layers,

characterized in that the coefficient of expansion of the layer of the n-ary III–V compound is higher than the (apparent) coefficient of expansion of the complementary layer(s), and in that the vitreous support which permits of controlling the compression extension state of the said semiconductor layer over a large temperature range, is formed by two different glasses sealed together, namely:

a) a supporting glass having a coefficient of expansion and a softening temperature which is higher than the (apparent) coefficient of expansion of the complementary layer(s) and than the treatment temperatures of the said structure, respectively, after it has been realized,

b) an intermediate glass placed between the supporting glass and the complementary layer(s), having a softening temperature which is lower than that of the supporting glass.

2. A vitreous semiconductor supporting structure as claimed in Claim 1, characterized in that the vitreous support is constituted:
a) by the intermediate glass formed by the glass such as is available from CORNING Company under reference 7056;
b) by the supporting glass formed by the glass such as is available from SCHOTT Company under the reference 8436.

3. A vitreous semiconductor supporting structure as claimed in Claim 1, characterized in that the vitreous support is constituted:
a) by the intermediate glass formed by a glass termed Ca B Al Si having the following composition in mol percent:
CaO 20 to 30%, $B_2O_3$ 50 to 60%, $Al_2O_3$ 5 to 10%, $SiO_2$ 10 to 15%;
b) by the supporting glass formed by the glass such as is available from SCHOTT Company, under reference 8436.

4. A photocathode, characterized in that it comprises a vitreous semiconductor supporting structure as claimed in any of the Claims 1 to 3.

5. A charge transfer device, characterized in that it comprises a vitreous semiconductor supporting structure as claimed in any of the Claims 1 to 3.

## Patentansprüche

1. Halbleiter-Glasträgerstruktur, die aus den folgenden Teilen besteht:
- Halbleiterschichten, die aus mindestens einer elektrisch und/oder optisch aktiven Schicht einer n-ären III–V-Verbindung und mindestens einer komplementären Schicht besteht,
- und einem Glasträger zum Tragen der Halbleiterschichten,

dadurch gekennzeichnet, dass der Ausdehnungskoeffizient der Schicht der n-ären III–V-Verbindung höher ist als der (scheinbare) Ausdehnungskoeffizient der komplementären Schicht(en) und dass der Glasträger, durch den eine Regelung des Zustandes der Kompression und Ausdehnung der Halbleiterschichten über einen grossen Temperaturbereich möglich ist, aus zwei verschiedenen zusammengeschweissten Gläsern besteht und zwar:

a) einem Trägerglas mit einem Ausdehnungskoeffizienten und einer Erweichungstemperatur der bzw. die höher ist als der (scheinbare) Ausdehnungskoeffizient der komplementären Schicht(en) bzw. den Temperaturen der Behandlung der Struktur, nach der diese verwirklicht worden ist.

b) einem Pufferglas zwischen dem Trägerglas und der (den) komplementären Schicht(en), wobei die Erweichungstemperatur niedriger ist als die des Trägerglases.

2. Halbleiter-Glasträgerstruktur nach Anspruch 1, dadurch gekennzeichnet, dass der Glasträger aus den folgenden Teilen besteht:
a) einem Pufferglas, das aus demjenigen Glas hergestellt ist, das von der Firma CORNING unter der Bezeichnung 7056 vertrieben wird,
b) einem Trägerglas, das aus demjenigen Glas hergestellt ist, das von der Firma SCHOTT unter der Bezeichnung 8436 vertrieben wird.

3. Halbleiter-Glasträgerstruktur nach Anspruch 1, dadurch gekennzeichnet, dass der Glasträger aus den folgenden Teilen besteht:
a) einem Pufferglas aus einem als Ca B Al Si bezeichneten Glas mit der folgenden zentesimalen molaren Verbindung:
CaO 20 bis 30%, $B_2O_3$ 50 bis 60%, $Al_2O_3$ 5 bis 10%, $SiO_2$ 10 bis 15%;
b) einem Trägerglas, das aus demjenigen Glas hergestellt ist, das unter der Bezeichnung 8436 von der Firma SCHOTT vertrieben wird.

4. Photokathode, dadurch gekennzeichnet, dass diese eine Halbleiter-Glasträgerstruktur nach einem der Ansprüche 1 bis 3 aufweist.

5. Ladungsübertragungsanordnung, dadurch gekennzeichnet, dass diese eine Halbleiter-Glasträgerstruktur nach einem der Ansprüche 1 bis 3 aufweist.

FIG.1

FIG.2

FIG.3